# EUROPEAN PATENT APPLICATION

(11) **EP 4 280 417 A1**
(43) Date of publication of application: **22.11.2023**
(21) Application number: 23169861.4
(22) Date of filing: 25.04.2023
(51) Int. Cl.: H02J 7/00, B60L 58/12, B60L 58/16, G01R 31/387, G01R 31/389, G01R 31/392

(54) **METHODS AND SYSTEMS FOR ENHANCING BATTERY CONFIGURATION AND PERFORMANCE**

(30) Priority: 09.05.2022 US 202217739586
(71) Applicant: The Boeing Company, Arlington, VA 22202 (US)
(72) Inventor: Lacaux, Frederic, Arlington 22202 (US); Trela, John A., Arlington 22202 (US); Brown, Glen M., Arlington 22202 (US); Karimi, Kamiar J., Arlington 22202 (US); Barekatein, Mehdy, Arlington 22202 (US)
(74) Representative: Witte, Weller & Partner Patentanwälte mbB

(57) **Abstract**

An example method includes receiving, from one or more sensors of a battery module (100), sensor information indicative of a health status of the battery module; determining (804), based on sensor information, battery health parameters of the battery module (100); determining (806), based on the battery health parameters, a target state-of-charge (SoC) indicating a target battery capacity to which the battery module (100) is to be charged; determining (808) an end-of-charge voltage (EOCV) to be attained at an end of charging the battery module (100) to achieve the target SoC; and commanding (810) a battery charger (420) to charge the battery module (100) until the EOCV is achieved.

## Description

### FIELD

The present invention relates generally to enhancing battery system design, safety, and performance by dynamic control of battery end-of-charge voltage over a service life of the battery.

### BACKGROUND

High energy density energy storage devices are capable of storing relatively high amounts of electrical energy per unit mass. For example, lithium-ion batteries may be capable of providing greater than 150 watt-hour (Wh) per kilogram of battery. In contrast, lead-acid batteries may only be capable of supplying about 25 Wh per kilogram of battery. Therefore, high energy density energy storage devices are particularly attractive when overall weight is a consideration, such as, for example, on commercial aircraft and personal electronics.

However, during operation of a lithium-ion battery, strong exothermic reactions may occur and might generate high temperatures and pressures. One prior approach to addressing the effects of such exothermic reactions includes the use of metal-based shielding (e.g., a thick enclosure) to contain venting during a strong exothermic reaction event. However, such shielding significantly increases overall weight.

Another approach includes using heat-absorbing material between cells of the battery. Such inter-cell material is sized to absorb the heat energy generated during cell exothermic reactions that generate high temperatures and protect adjacent cells. However, packing thick heat-absorbing materials between cells may increase the weight of a battery module and preclude packing cells efficiently, e.g., packing cells close to each other to fit more cells in a given volume.

It may thus be desirable to use alternative ways to address strong exothermic reactions within a battery. It is with respect to these and other considerations that the disclosure made herein is presented.

### SUMMARY

The present disclosure describes examples that relate to a methods and systems for enhancing battery configuration and performance.

In one aspect, the present disclosure describes a system. The system includes: a battery module having a plurality of battery cells, wherein the battery module includes one or more sensors providing sensor information indicative of a health status of the battery module; a battery charger configured to provide electric power to the battery module to charge the battery module; and a battery charging controller comprising (i) one or more processors, and (ii) data storage storing thereon instructions that, when executed by the one or more processors, cause the battery charging controller to perform operations comprising: determining, based on the sensor information received from the one or more sensors of the battery module, battery health parameters of the battery module; determining, based on the battery health parameters, a target state-of-charge (SoC) indicating a target battery capacity to which the battery module is to be charged; determining an end-of-charge voltage (EOCV) to be attained at an end of charging the battery module to achieve the target SoC; and commanding the battery charger to charge the battery module until the EOCV is achieved.

In another aspect, the present disclosure describes a method. The method includes: (i) receiving, at a battery charging controller of a battery module, from one or more sensors of the battery module, sensor information indicative of a health status of the battery module; (ii) determining, by the battery charging controller, based on sensor information, battery health parameters of the battery module; (iii) determining, by the battery charging controller, based on the battery health parameters, a target state-of-charge (SoC) indicating a target battery capacity to which the battery module is to be charged; (iv) determining, by the battery charging controller, an end-of-charge voltage (EOCV) to be attained at an end of charging the battery module to achieve the target SoC; and (v) commanding, by the battery charging controller, a battery charger to charge the battery module until the EOCV is achieved.

In another aspect, the present disclosure describes a non-transitory computer readable medium having stored therein instructions that, in response to execution by a battery charging controller of a battery module, cause the battery charging controller to perform operations including: (i) determining, based on sensor information received from one or more sensors of the battery module, battery health parameters of the battery module; (ii) determining, based on the battery health parameters, a target state-of-charge (SoC) indicating a target battery capacity to which the battery module is to be charged; (iii) determining an end-of-charge voltage (EOCV) to be attained at an end of charging the battery module to achieve the target SoC; and (iv) commanding a battery charger to charge the battery module until the EOCV is achieved.

The foregoing summary is illustrative only and is not intended to be in any way limiting. In addition to the illustrative aspects, examples, and features described above, further aspects, examples, and features will become apparent by reference to the figures and the following detailed description.

### BRIEF DESCRIPTION OF THE FIGURES

The novel features believed characteristic of the illustrative examples are set forth in the appended claims. The illustrative examples, however, as well as a preferred mode of use, further objectives and descriptions thereof, will best be understood by reference to the following detailed description of an illustrative example of the present disclosure when read in conjunction with the accompanying Figures.
Figure 1 illustrates a schematic diagram of a battery module, in accordance with an example implementation.
Figure 2 illustrates a graph depicting degradation of battery capacity over life of a battery, in accordance with an example implementation.
Figure 3 illustrates a graph depicting adjustments to State of Charge of a battery module over its life, in accordance with an example implementation.
Figure 4 illustrates a block diagram of a system including a battery charging controller, in accordance with an example implementation.
Figure 5 illustrates a graphic representation of correspondence between an End-of-Charge voltage and a State of Charge of a Lithium-Ion battery module, in accordance with an example implementation.
Figure 6 illustrates schematically lowering a State of Charge of a battery module, in accordance with an example implementation.
Figure 7 illustrates a graph showing gradual adjustment of an End-of-charge Voltage, in accordance with an example implementation.
Figure 8 is a flowchart of a method for control of charging of a battery module, in accordance with an example implementation.
Figure 9 is a flowchart of additional operations that may be executed and performed with the method of Figure 8, in accordance with an example implementation.
Figure 10 is a flowchart of additional operations that may be executed and performed with the method of Figure 8, in accordance with an example implementation.
Figure 11 is a flowchart of additional operations that may be executed and performed with the method of Figure 8, in accordance with an example implementation.
Figure 12 is a flowchart of additional operations that may be executed and performed with the method of Figure 8, in accordance with an example implementation.
Figure 13 is a flowchart of additional operations that may be executed and performed with the method of Figure 8, in accordance with an example implementation.
Figure 14 is a block diagram of an example computing device, according to an example implementation.

### DETAILED DESCRIPTION

Disclosed examples will now be described more fully hereinafter with reference to the accompanying drawings, in which some, but not all of the disclosed examples are shown. Indeed, several different examples may be described and should not be construed as limited to the examples set forth herein. Rather, these examples are described so that this disclosure will be thorough and complete and will fully convey the scope of the disclosure to those skilled in the art.

Batteries, such as Lithium-Ion (Li-Ion) batteries, are capable of storing relatively high amounts of electrical energy per unit mass, and are thus used in many air and ground transportation. Under some operating conditions, strong exothermic reactions or other events may occur within a cell of a battery, thereby generating a large amount of heat that can affect performance of the cell and performance of neighboring cells. As such, performance of the battery may be affected. The term "strong exothermic reaction" is used herein to indicate chemical reactions that generate an amount of heat within the battery that may exceed the amount of heat dissipated to its surroundings. Such chemical reactions may be accelerated by increased temperature, in turn releasing energy that further increases temperature. A strong exothermic reaction may occur as a result of an internal short circuit in the battery or battery cell, puncture of the battery cell, increased temperature or heat around the cell, as examples.

Within examples described herein are systems and methods involving dynamically adjusting the maximum state of charge of battery cells or modules via charging the battery cells/modules to pre-determined values to ensure enhanced system design and safety, and to tolerate and mitigate the effects of thermal propagation that might occur at higher states of charge.

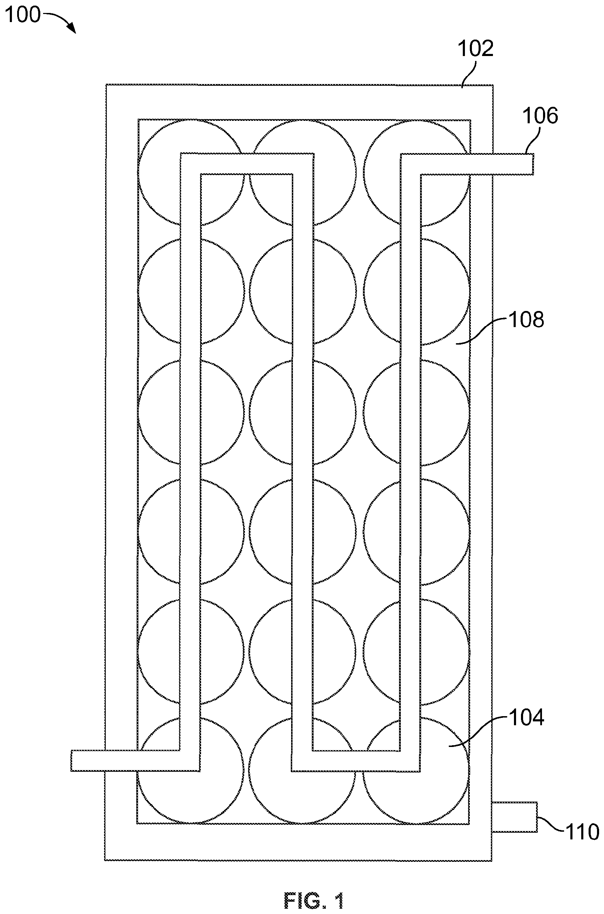

Figure 1 illustrates a schematic diagram of a battery module 100, in accordance with an example implementation. The battery module 100 can be a Lithium-ion (Li-Ion) battery, for example. The battery module 100 includes a housing or enclosure 102 that houses a plurality of battery cells arranged in rows and columns, such as battery cell 104. The battery cells can be cylindrical cells as illustrates, but can also take other shapes.

The enclosure 102 is configured as a mechanical enclosure that protects the battery cells disposed therein and also precludes the battery module 100 from affecting surrounding devices or components outside the battery module 100 in the case the battery malfunctions. As such, the thickness of the wall of the enclosure 102 and the weight of the enclosure are determined based on a maximum amount of heat and pressure that are expected to be generated within the battery module 100.

The battery module 100 also includes an electrical connection 106 (e.g., an electric bus) that electrically connects the battery cells, e.g., in series. However, it should be understood that the cells can be configured to have a parallel electrical connection. A series electrical connection is used herein as an example. The electrical connection 106 can then be provided outside the enclosure 102 to be connected externally to a power-consuming device (e.g., electric motor, consumer electronics, or any other device that uses electric power). As such, the battery cells of the battery module 100 represent a battery string or bank comprising a number of cells connected in series via the electrical connection 106 to generate a desired usable voltage/potential, e.g., 6 Volts (V), 12V, 24V, 48V, 110V, etc.

The battery module 100 further includes inter-cell material 108 that substantially fills the space between the battery cells. The inter-cell material 108 is configured to have heat-absorbing characteristics to facilitate absorbing heat generated by the battery cells in the case of strong exothermic reactions generating high temperatures within the enclosure 102.

Further, during such strong exothermic reactions occurring in the battery module 100, gases might be generated within the enclosure 102. As such, the battery module 100 can further include a venting system to evacuate safely the gas generated by one or more of the battery cells of the battery module 100. For instance, the battery module 100 can include a gas venting port 110 configured to vent or release gas and avoid over-pressurization within the enclosure 102.

During operation of the battery module 100, one or more of the cells, such as the battery cell 104, may be susceptible to events such as an internal short circuit, puncture, external heat, etc. Such events may result in strong exothermic reactions that generate a large amount of heat and pressure, resulting in high temperatures within the enclosure 102.

The high thermal energy release by a particular battery cell may affect surrounding cells and potentially create a cascading event with adjacent cells being degraded. Further, high thermal energy release from multiple cells at the same time may affect performance of the battery module 100 as a whole as well as neighboring modules and devices. As such, design and configuration of the battery module 100 take into consideration a worst case scenario and account for a large amount of thermal release by making the enclosure 102 thick and heavy, and additionally have the inter-cell material 108 being thick and capable of absorbing large amounts of heat to preclude one event in one cell from propagating to neighboring cells.

However, such design considerations increase the weight of the battery module 100 and may affect the arrangement or packaging of the battery cells within the enclosure 102. For example, a lower number of battery cells is included in the battery module 100 to have large spaces between the cells filled with thick inter-cell material. As a result, energy or power density of the battery module 100 might be reduced compared to an arrangement where more cells are packaged in the enclosure 102 more efficiently.

It may thus be desirable to reduce the energy release by a battery cell during a strong exothermic reaction event to improve the weight of the battery module 100 and enhance the power density of the battery module 100, e.g., by reducing the penalty of the design considerations implemented against heat propagation such as increased weight and thickness of the enclosure 102 and the inter-cell material 108. One way to achieve this is to use less energetic cells (i.e., cells that produce a lesser amount of energy in the case of a strong exothermic reaction). This way, heat propagation to neighboring cells may be mitigated. However, less energetic cells tend to have lower nominal performances (e.g., less watt-hour energy per kilogram (Wh/kg) or less kilowatts per kg (kW/kg).

It may thus be desirable to use highest performing battery cells with the highest power density with minimum packaging impact, while also preventing thermal heat propagation from cell to cell. Particularly, as described in detail below, the maximum state of charge of the cells or the battery module 100 is dynamically adjusted via charging to pre-determined values to ensure enhanced system design and safety, and to tolerate and mitigate the effects of thermal propagation that might occur at higher states of charge. Further, adjustments to the maximum state of charge over the life of the battery module 100 may enable enhancing performance and life of the battery module 100 by reducing cell performance degradation, which may otherwise occur at traditional, higher states of charge.

Batteries, such as Li-Ion battery, degrade over time. For example, while at the beginning of life of the battery module 100, it can be charged to a 100% of its capacity, at the end of life of the battery module 100, it can be charged to a lesser capacity such as 70% or 85%. The term "battery capacity" is used herein to indicate a measure, e.g., in Ampere-hour (Ah), of the charge stored in the battery module 100, and is determined by the mass of active material contained in the battery module 100. The battery capacity may thus represent the maximum amount of energy that can be extracted from the battery module 100 under certain specified conditions.

As an example for illustration, the battery capacity is the electric current a battery can provide over a specified period of time. For example, a battery capacity of 100Ah at C10 rate to end-of-discharge (EOD) of 2.5V/cell indicates that the battery can provide 10 Amperes for 10 hours to an end of discharge voltage of 2.5V per battery cell. The End of discharge voltage is the level to which the voltage of the battery module 100 or cell voltage is allowed to fall to before affecting the load, e.g., 2.5V or 17.5V on a nominal 24V system.

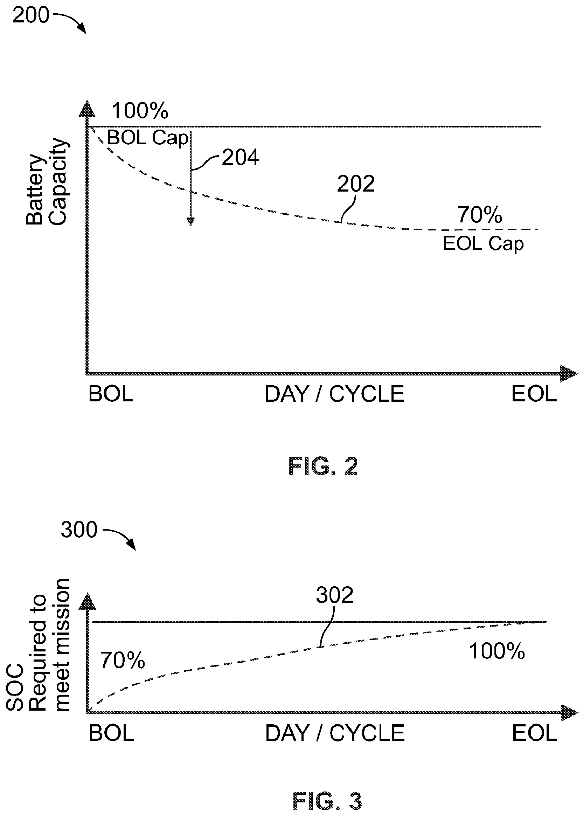

Figure 2 illustrates a graph 200 depicting degradation of battery capacity over life of a battery. The y-axis represents the battery capacity of the battery module 100, and the x-axis represents the life of the battery module 100 in days or cycles. A cycle life of the battery module 100 represents the number of cycles (charge/discharge) the battery module 100 provides before it is no longer usable. For example, a battery is considered non-usable if its nominal capacity falls below 70 to 80 percent.

As shown in Figure 2, at the beginning of life of the battery module 100, it can have a beginning-of-life (BOL) capacity of 100% as the battery module 100 has not been degraded yet. Over the life of the battery module 100, it ages and loses energy storing capability (capacity loss) and power capability (impedance increase) as shown by line 202. For example, capacity of the battery module 100 decreases and may reach an end-of-life (EOL) capacity of about 70% of its maximum BOL capacity as indicated by arrow 204.

Battery impedance is a combination of internal resistance and reactance, where reactance is a measure of the opposition that a circuit or a part of a circuit presents to an electric current by inductance or capacitance. The internal resistance of a battery is made up of two components: electrical or Ohmic resistance and ionic resistance. Electrical resistance is a measure of the opposition to current flow in an electrical circuit whereas ionic resistance is a measure of opposition to current flow due to internal factors such as electrode surface area and electrolyte conductivity. Internal Ohmic resistance values can indicate the overall health of a battery. A lower internal resistance/impedance generally indicates a higher capacity, and an increase in internal resistance/impedance over time can indicate declining battery capacity, or degradation.

A battery is designed to meet specific mission requirement for energy and maximum battery peak power of the system using the battery when the capacity of the battery is degraded. Battery end of life can be determined as when the battery is not capable of meeting either its energy or power requirements. As there is correlation between capacity loss and impedance growth, battery end of life can be identified with a percentage of battery capacity fade (e.g., 30% capacity fade to a 70% EOL capacity). When the battery has reached the EOL capacity (e.g., 70%), the battery is not capable of meeting its power requirement or it energy requirement.

The battery (e.g., the battery module 100) is configured from a sizing standpoint (e.g., number of battery cells, size of the enclosure 102, etc.), such that the battery capacity at its end of life is sufficient for the system mission energy requirements. As an example for illustration, if the EOL capacity of the battery is 70% of battery BOL capacity, the battery module 100 is configured to meet the system mission energy requirement with 70% capacity.

Thus, if the battery module 100 can meet its energy output requirement with an EOL capacity of 70% of maximum BOL capacity, then charging the battery module 100 to 100% capacity at the beginning of life indicates a 30% excess energy that is not needed or used. Therefore, charging the battery module 100 with a defined constant End-Of-Charge Voltage (EOCV) (e.g., 4.2 V/cell) corresponding at a State of Charge (SoC) of 100% throughout the life of the battery module 100 regardless of whether the battery module 100 is at the beginning of life or near its end of life is not optimal.

As such, it may be desirable to dynamically adjust the SoC of the battery module 100 throughout its life to take into account aging of the battery without impacting the energy requirements of the battery module 100. The SoC can be defined as the ratio of the available capacity Q(t) and the maximum possible charge that can be stored in a battery, i.e., the nominal capacity Qₙ. A fully charged battery has SoC of 100% while a fully discharged battery has a SoC of 0%. Thus, SoC is the level of charge of an electric battery relative to its capacity. The SoC is expressed in percentages, for example.

Figure 3 illustrates a graph 300 depicting adjustments to SoC of the battery module 100 over its life, in accordance with an example implementation. The y-axis represents the SoC required to meet energy requirements (mission requirement) of the battery module 100, and the x-axis represents the life of the battery module 100 in days or cycles. As depicted by line 302, it may be desirable to charge the battery module 100 with an SoC of 70%, for example, at the beginning of life (i.e., when BOL capacity is 100%). Then, the SoC is dynamically, progressively adjusted (e.g., increased) over the life of the battery module 100 based on aging of the battery module 100 until reaching an SoC of 100% at the end of life, when the EOL capacity of the battery module 100 is 70%, for example, of its maximum BOL capacity. This way, a charging controller of the battery module 100 adjusts the SoC over the life of the battery module 100 to take into account aging, while storing sufficient energy in the battery module 100 to meet its mission requirements.

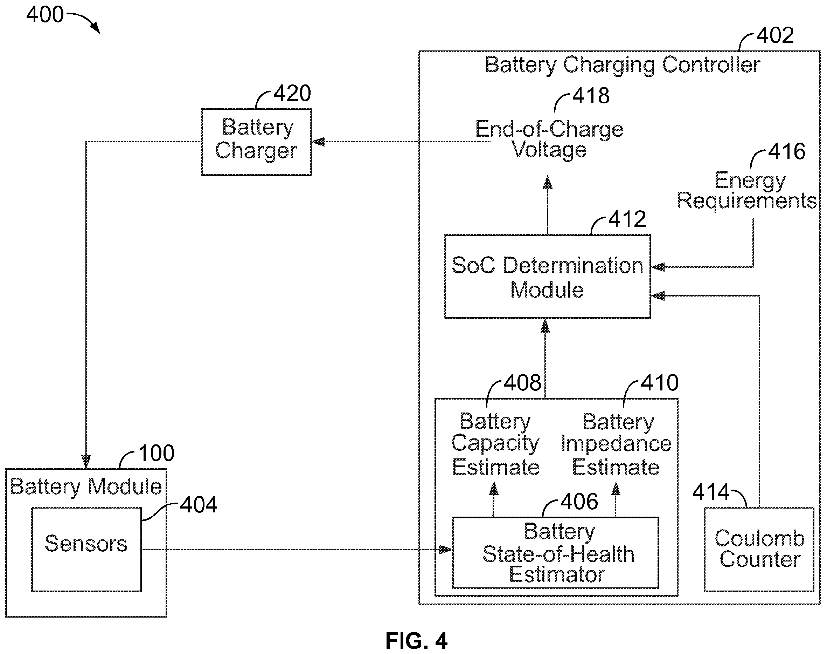

Figure 4 illustrates a block diagram of a system 400 including a battery charging controller 402, in accordance with an example implementation. The battery charging controller 402 can have a respective microprocessor that can include one or more processors. A processor can include a general purpose processor (*e.g*., an INTEL^{®} single core microprocessor or an INTEL^{®} multicore microprocessor, ARM, Qualcomm, or AMD processors), or a special purpose processor (*e.g*., a digital signal processor, a graphics processor, or an application specific integrated circuit (ASIC) processor). A processor can be configured to execute computer-readable program instructions (CRPI) to perform the operations described throughout herein. A processor can be configured to execute hard-coded functionality in addition to or as an alternative to software-coded functionality (*e.g*., via CRPI).

The battery charging controller 402 is configured to control charging the battery module 100 to enable the battery module 100 to be configured in an enhanced way, and to enhance its safety and performance over its service life. Particularly, the objective of the battery charging controller 402 is to maintain substantially the same energy level stored in the battery module 100 throughout the life of the battery module 100, while taking into consideration aging of the battery module 100. With a given level of energy stored in the battery module 100, the energy released during a strong exothermic reaction event may be maintained constant during the life of the battery module 100. More specifically, to control the energy level stored in the battery module 100 substantially constant during its life, the battery charging controller 402 varies the EOCV, which in turn changes the SoC of the battery module 100, over the life of the battery module 100.

The battery module 100 can include sensors 404. The sensors 404 can include, as example, one more of an ambient temperature sensor, cell temperature sensors, voltage sensor indicating voltage output of the battery module 100 or its individual cells, a current sensor indicating current output of the battery module 100, a pressure sensor (e.g., used in modules with a pouch of prismatic cells to measure pressure increases and cell expansion throughout life), etc. As such, the sensors 404 are configured to a provide indicators of a health status of the battery module 100.

The battery charging controller 402 includes a battery state-of-health estimator 406 that receives the sensor information from the sensors 404. Additionally, the battery state-of-health estimator 406 can have access to other information (e.g., stored in a memory or database) such as cycling current/voltage patterns of the battery module 100 and user profiles of the user of the battery module 100. Based on such additional information, the battery state-of-health estimator 406 can identify patterns of how the battery module 100 is charged and discharged (e.g., a particular level to which the battery module 100 is drained before being charged, the level to which the battery module 100 is charged, etc.).

Based on the sensor information from the sensors 404 and any other additional information, the battery state-of-health estimator 406 estimates aging characteristic of the battery module 100. The battery state-of-health estimator 406 uses the received information to determine battery degradation (e.g., capacity fade, impedance growth, etc.) over the life of the battery module 100 to provide a real time estimate of the performance and capability of the battery module.

In an example, the battery state-of-health estimator 406 can have access to battery aging models generated by testing performance and aging characteristics of many batteries. Such models are configured to map or correlate current battery conditions as well as patterns (cycling and charge/discharge cycles) to aging characteristics of the battery.

For example, inputs to such models can include the sensor information received from the sensors 404 (e.g., voltage level, current level, temperature, etc.) and additional information (e.g., charge/discharge cycle patterns). The outputs of the models includes parameters or variables that are indicative of a current health status of the battery module 100. For example, as shown in Figure 4, the battery state-of-health estimator 406 can generate a battery capacity estimate 408 and a battery impedance estimate 410.

The battery capacity estimate 408 can, for example, provide an estimate of a maximum battery capacity at a given point in the life of the battery module 100, and the battery impedance estimate 410 can, for example, provide an indication of the internal resistance of the battery module 100 at the given point in the life of the battery module 100. At the beginning of life of the battery module 100, the battery capacity estimate 408 can be about 100% and the battery impedance estimate 410 can be a low value. As the battery module 100 ages over time, the battery capacity estimate 408 decreases and the battery impedance estimate 410 increases.

In an example, the battery state-of-health estimator 406 can take into consideration other information. For instance, the battery capacity estimate 408 can differ based on whether the battery module 100 is in a discharge phase or a charge phase. As such, the battery state-of-health estimator 406 can use the specific operating phase of the battery module 100 to integrate the consumed energy (e.g., to determine accumulated energy discharge) and correlate, re-align, or refine the battery capacity estimate 408. In another example, the ambient temperature in the environment of the battery module 100 can may be taken into consideration in determining the battery capacity estimate 408.

In another example, the battery charging controller 402 can perform or operate the battery module 100 in an integrated automatic maintenance mode to check the capacity of the battery module 100 and re-align or refine the battery capacity estimate 408. For instance, during a maintenance period of, additional testing can be performed to calibrate the battery state-of-health estimator 406.

The battery charging controller 402 further includes a SoC Determination Module 412 in communication with the battery state-of-health estimator 406. The term "module" is used throughout herein to indicate hardware components, software components, or a combination of both.

The SoC Determination Module 412 receives information indicative of the age or the aging characteristics of the battery module 100 (e.g., the battery capacity estimate 408 and the battery impedance estimate 410) from the battery state-of-health estimator 406. The SoC Determination Module 412 then determines a desirable SoC or a target SoC to which the battery module 100 is to be charged (e.g., the charging level to which the battery module 100 is to be charged) that may enhance the life of the battery module 100 and reduce the amount of heat generated in the event of a strong exothermic reaction.

In an example, the battery charging controller 402 can further include a coulomb counter 414. The coulomb counter 414 is a feature or device that measures the accumulated energy added to and removed from the battery module 100, allowing for accurate estimates of battery charge level. For example, the coulomb counter 414 can track the SoC of the battery module 100 by integrating the active flowing current (measured in Amperes) over time to derive the total sum of energy entering or leaving the battery module 100. The result of such integration is, or can be correlated to, a battery capacity that is typically measured in Ampere-hours.

In this example, the battery charging controller 402 can use the coulomb counter 414 to keep track of the energy stored in the battery module 100 during charge and discharge modes. As such, the coulomb counter 414 can be used as a feedback variable that is provided to the SoC Determination Module 412 to adjust the target SoC for the battery module 100.

Additionally, the SoC Determination Module 412 has access to energy requirements 416 of the battery module 100. The energy requirements 416 represents, for example, the power output level or the energy that the battery module 100 is expected to provide to meet the system specification or mission (e.g., operate a device powered by the battery module 100 according to specification or as expected). The energy requirements 416 can also include or specify a duration of a mission. For example, if the battery module 100 is used in a vehicle (car, aircraft, etc.), the energy requirements 416 can specify a duration of a mission (e.g., 30 minutes, 1 hours, 3 hours, etc.) during which the battery module 100 is expected to keep providing power.

Based on inputs to the SoC Determination Module 412 (e.g., inputs including battery aging parameters, input from the coulomb counter 414, and the energy requirements 416), the SoC Determination Module 412 generates a target SoC for the battery module 100 that meets the energy requirements 416, while enhancing the life of the battery module 100 and reducing the amount of heat generated in the event of a strong exothermic reaction. For example, the SoC Determination Module 412 can determine at the beginning of life of the battery module 100 that the desired SoC is 70% or 85% of its BOL maximum capacity.

The SoC of the battery module 100 corresponds to a particular EOCV (EOCV can be defined as the voltage attained at the end of charging of the battery module 100, at a specified constant current). In other words, setting the EOCV of the battery module 100 corresponds to setting the SoC of the battery module 100. As example, an EOCV of 3.8 V/cell may correspond to a SoC of 85%, while an EOCV of 4.0 V/cell may correspond to a SoC of 100%.

Thus, based on the target SoC determined by the SoC Determination Module 412, the SoC Determination Module 412 determines an End-of-Charge Voltage 418 corresponding to the target SoC. The battery charging controller 402 then provides the End-of-Charge Voltage 418 to (or uses the End-of-Charge Voltage 418 to control) a battery charger 420.

The battery charger 420 is a device that provides electric power to the battery module 100, which then converts the electric power into stored chemical energy for storage in the electrochemical cells of the battery module 100 by running an electric current through them. The battery charger 420 continues to supply electric power to the battery module 100 until the End-of-Charge Voltage 418 is reached. Once the End-of-Charge Voltage 418 is reached, the battery charger 420 terminates the charging process.

In an example, the energy requirements 416 can also affect the charge time of the battery module. As an example for illustration, the battery module 100 can be used to provide electric power to systems of an aircraft. An aircraft mission that is a 100 nautical mile (nm) mission might require 75% capacity of the battery module, whereas a shorter 50 nm mission might require 50% capacity of the battery module 100. In this example, the battery charging controller 402 can command the battery charger 420 to charge the battery module 100 for a longer duration (e.g., 30 minutes) compared to the charging time for the shorter mission (e.g., for the shorter mission, the charging time may be 20 minutes). The shorter charging time, which results in a lower SoC can beneficially reduce the thermal release in case there is a strong exothermic reaction within the battery module 100.

Components of the system 400 may be configured to work in an interconnected fashion with each other and/or with other components coupled to respective systems. One or more of the described operations or components of the system 400 may be divided up into additional operational or physical components, or combined into fewer operational or physical components. In some further examples, additional operational and/or physical components may be added to the system 400. Still further, any of the components or modules of the system 400 may include or be provided in the form of a processor (e.g., a microprocessor, a digital signal processor, etc.) configured to execute program code including one or more instructions for implementing logical operations described herein. The system 400 may further include any type of computer readable medium (non-transitory medium) or memory, for example, such as a storage device including a disk or hard drive, to store the program code that when executed by one or more processors cause the system 400 to perform the operations described above. In an example, the system 400 may be included within other systems.

As mentioned above, at the beginning of life of the battery module 100, the battery module 100 can have capacity in excess of the energy requirements 416. Thus, the battery charging controller 402 (particularly, the SoC Determination Module 412) lowers the battery target SoC to reduce the energy that could be generated in the case of strong exothermic reaction event while meeting the energy requirements 416.

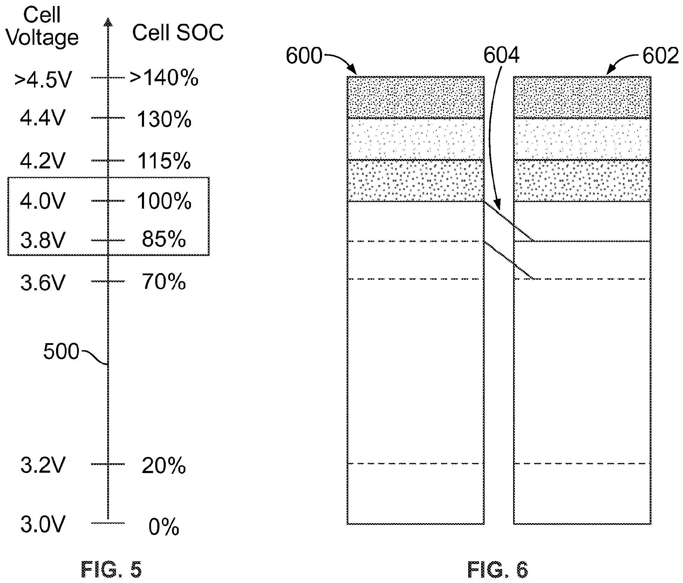

Figure 5 illustrates a graphic representation of correspondence between the End-of-Charge Voltage 418 and the SoC of the battery module 100, and Figure 6 illustrates schematically lowering the SoC of the battery module 100, in accordance with an example implementation. Particularly, Figure 5 illustrates an axis 500 with End-of-Charge voltage values on the left and corresponding SoC values on the right. The graph shown in Figure 5 corresponds to a Li-ion battery performance, as an example for illustration. It should be understood that the End-of-Charge voltage values and the SoC values used herein are examples for illustration only. These values may change based on cell chemistry and manufacturer specifications.

Figure 6 illustrates a first column 600 and a second column 602, each column having stacked blocks, each block corresponding to a range of End-of-Charge voltage values or a range of SoC values. End-of-Charge voltage values equal to or less than 4V (e.g., 3V, 3.2V, 3.6V, 3.8 V, and 4V) and corresponding SoC values (e.g., 0%, 20%, 70%, 85%, and 100%) represent safe operation ranges for the battery module 100. Above 4V (e.g., 4.2V, 4.4V, or 4.5V and corresponding SoC values of 115%, 130%, or 140%) are considered unsafe and may damage the battery module 100.

The first column 600 represents charging the battery module 100 to its full capacity at the beginning of life without adjustments, whereas the second column 602 represents lowering the SoC of the battery module 100 at the beginning of life. As shown schematically via lines 604 in Figure 6, at the beginning of life of the battery module 100, the battery charging controller 402 reduces the End-of-Charge Voltage 418 (e.g., from 4V to 3.8V) so as to reduce the SoC of the battery module 100 from 100% to 85%, for example. This way, the energy stored in cells of the battery module 100 is reduced, thereby reducing the amount of heat that could result in the case of a strong exothermic reaction, rendering the battery module 100 safer, while also meeting the energy requirements 416.

Over the life of the battery module, the battery charging controller 402 is configured to dynamically and continually adjust the End-of-Charge Voltage 418 based on the information received from the battery state-of-health estimator 406 (e.g., the battery capacity estimate 408, the battery impedance estimate 410, aging parameters of the battery module 100, etc.). Particularly, the battery charging controller 402 can increase the End-of-Charge Voltage 418 (and thus increase the SoC) as the battery module 100 ages over its service life. Particularly, as the cells of the battery module 100 age, resulting in increase in internal impedance and loss of active lithium (and energy capacity), the End-of-charge Voltage 418 may be increased gradually (e.g., in increments of 5-10 millivolts) to offset such performance loss, thereby maintaining an equivalent amount of energy in the battery module 100, without compromising safety.

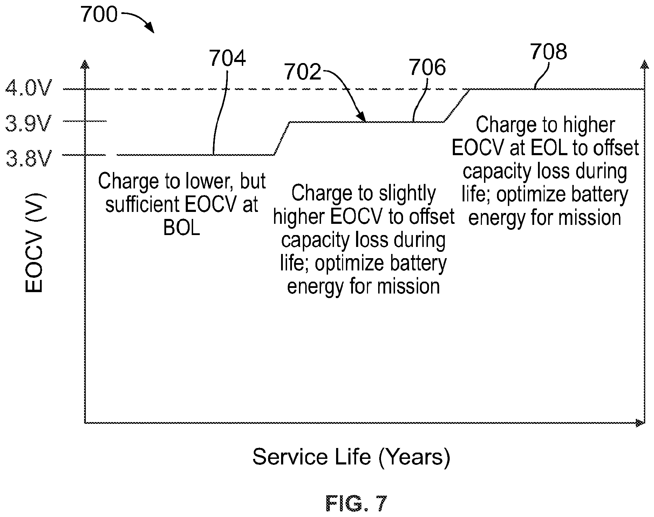

Figure 7 illustrates a graph 700 showing gradual adjustment of the End-of-charge Voltage 418, in accordance with an example implementation. The x-axis of the graph 700 represents service life of the battery module 100 in years, for example. The y-axis represents the End-of-charge Voltage 418 in Volts (V). The graph 700 includes line 702 depicting variation or adjustments in the End-of-charge Voltage 418 over the life of the battery module 100.

During a first period 704 of the life of the battery module 100, the battery charging controller 402 charges the battery module 100 to an EOCV value of 3.8V, which corresponds to a SoC of about 85%, for example. This state is sufficient to meet the energy requirements 416, while reducing thermal release in the event of a strong exothermic reaction event, and may also reduce cell performance degradation of the battery module 100. As an example, the first period 704 may last for a few months to a year.

As the battery module 100 ages, the battery capacity estimate 408 decreases and the battery impedance estimate 410 increases, indicating that the battery module 100 has aged. Responsively, the battery charging controller 402 increases the EOCV to a value of 3.9V, for example, during a second period 706 (e.g., another year to two years). The 3.9 V EOCV can correspond to a SoC of about 92.5%, for example.

As the battery module 100 ages further, the battery capacity estimate 408 continues to decrease and the battery impedance estimate 410 continues to increase, indicating that the battery module 100 has aged further. Responsively, the battery charging controller 402 increases the EOCV further to a value of 4V, for example, during a third period 708 (e.g., another year to two years). The 4V EOCV can correspond to a SoC of about 100%, for example.

The graph 700 shows variations occurring after months or years of service as an example to illustrate the control strategy. However, it should be understood that the battery charging controller 402 can be configured to continually and dynamically adjust the EOCV and the SoC of the battery module 100 in small increments and more often so as to continue to enhance performance, safety, and life of the battery module 100.

Such control strategy for charging the battery module 100 may offer several advantages. As capacity of the battery module 100 is reduced (i.e., capacity loss occurs), the SoC is increased to offset such capacity loss. This way, the battery module 100 continues to meet the energy requirements 416, while also mitigating the effects of any strong exothermic reaction. Further, adjustments in the SoC over the life of the battery module 100 may enable increasing the life of the battery module 100 by reducing cell performance degradation, which might otherwise occurs at higher states of charge.

Further, as the potential for thermal release is decreased due to implementing such control strategy, the weight of the enclosure 102 may be reduced (e.g., by reducing its thickness). Particularly, using such battery charging control strategy that reduces thermal release indicates that the enclosure 102 might be designed for containment of smaller thermal releases and temperature compared to battery modules that are not charged using the above-described strategy. Similarly, less quantities and sizes of the inter-cell material 108 may be used, thereby enabling packing more battery cells within the enclosure 102.

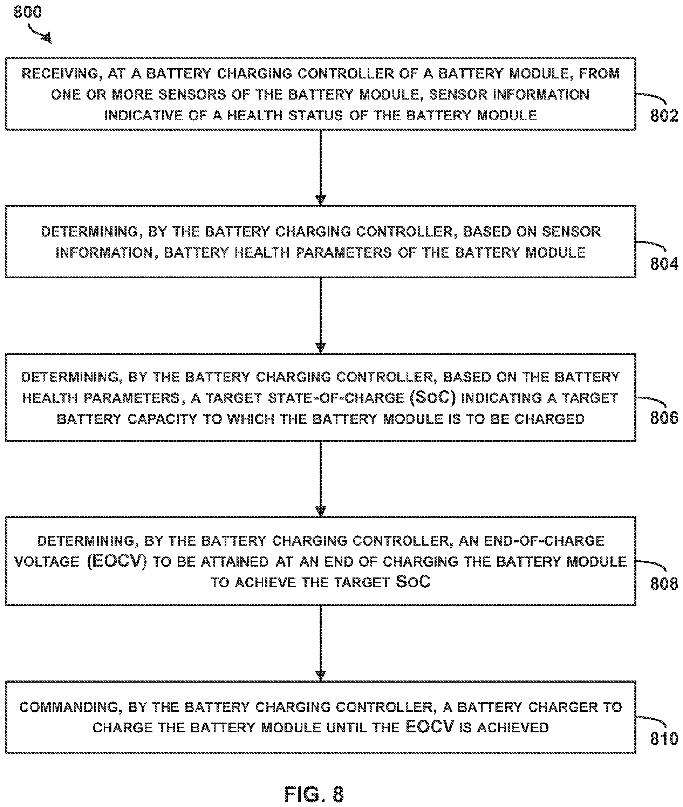

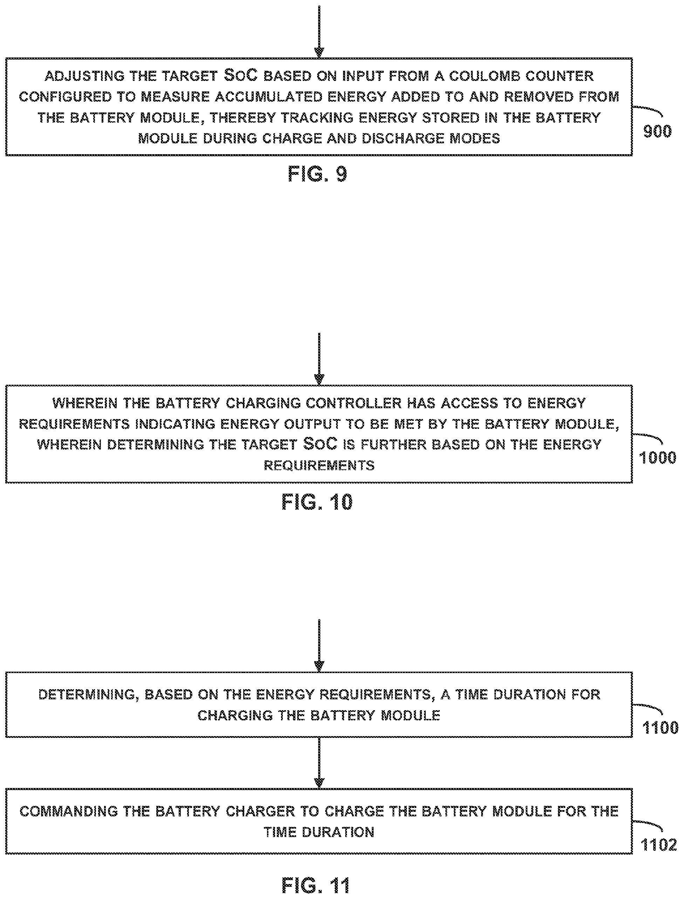

Figure 8 is a flowchart of a method 800 for control of charging of a battery module, in accordance with an example implementation. The method 800 can, for example, be performed by the battery charging controller 402 to control charging of the battery module 100. Further, Figures 9-13 are flowcharts of methods for use with the method 800.

The method 800 may include one or more operations, or actions as illustrated by one or more of blocks 802-810, 900, 1000, 1100-1102, 1200, and 1300. Although the blocks are illustrated in a sequential order, these blocks may in some instances be performed in parallel, and/or in a different order than those described herein. Also, the various blocks may be combined into fewer blocks, divided into additional blocks, and/or removed based upon the desired implementation.

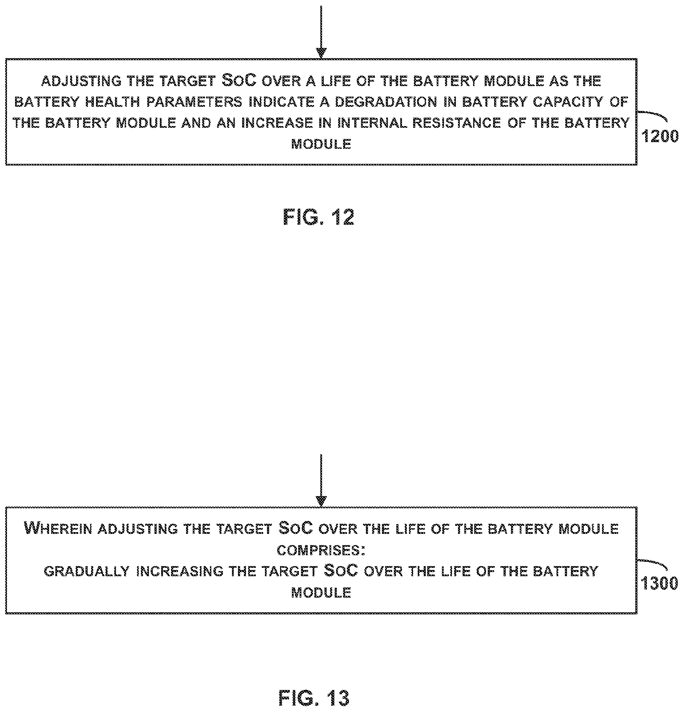

In addition, for the method 800 and other processes and operations disclosed herein, the flowchart shows operation of one possible implementation of present examples. In this regard, each block may represent a module, a segment, or a portion of program code, which includes one or more instructions executable by a processor (e.g., a processor or microprocessor of the battery charging controller 402) for implementing specific logical operations or steps in the process. The program code may be stored on any type of computer readable medium or memory, for example, such as a storage device including a disk or hard drive. The computer readable medium may include a non-transitory computer readable medium or memory, for example, such as computer-readable media that stores data for short periods of time like register memory, processor cache and Random Access Memory (RAM). The computer readable medium may also include non-transitory media or memory, such as secondary or persistent long term storage, like read only memory (ROM), optical or magnetic disks, compact-disc read only memory (CD-ROM), for example. The computer readable media may also be any other volatile or non-volatile storage systems. The computer readable medium may be considered a computer readable storage medium, a tangible storage device, or other article of manufacture, for example. In addition, for the method 800 and other processes and operations disclosed herein, one or more blocks in Figures 12-19 may represent circuitry or digital logic that is arranged to perform the specific logical operations in the process.

At block 802, the method 800 includes receiving, at a battery charging controller of a battery module, from one or more sensors of the battery module, sensor information indicative of a health status of the battery module. For example, the battery module 100 can include wherein the one or more sensors (e.g., the sensors 404), which include (i) an electric current sensor, (ii) a voltage sensors, or (iii) a temperature sensor. The output of the sensors indicate a health status of the battery module 100.

At block 804, the method 800 includes determining, by the battery charging controller 402, based on sensor information, battery health parameters of the battery module 100. As example, the battery health parameters can include the battery capacity estimate 408 providing an estimate of a maximum battery capacity at a given point in a life of the battery module 100, and/or the battery impedance estimate 410 providing an indication of an internal resistance of the battery module 100 at the given point in the life of the battery module 100.

At block 806, the method 800 includes determining, by the battery charging controller 402, based on the battery health parameters, a target SoC indicating a target battery capacity to which the battery module 100 is to be charged.

At block 808, the method 800 includes determining, by the battery charging controller 402, an EOCV to be attained at an end of charging the battery module 100 to achieve the target SoC.

At block 810, the method 800 includes commanding, by the battery charging controller 402, the battery charger 420 to charge the battery module 100 until the EOCV is achieved.

Figure 9 is a flowchart of additional operations that may be executed and performed with the method 800, in accordance with an example implementation. At block 900, operations include adjusting the target SoC based on input from the coulomb counter 414 configured to measure accumulated energy added to and removed from the battery module 100, thereby tracking energy stored in the battery module 100 during charge and discharge modes.

Figure 10 is a flowchart of additional operations that may be executed and performed with the method 800, in accordance with an example implementation. In an example, the battery charging controller 402 has access to the energy requirements 416 indicating energy output to be met by the battery module 100. At block 1000, operations include determining the target SoC further based on the energy requirements 416.

Figure 11 is a flowchart of additional operations that may be executed and performed with the method 800, in accordance with an example implementation. At block 1100, operations include determining, based on the energy requirements 416, a time duration for charging the battery module 100. At block 1102, operations further include commanding the battery charger 420 to charge the battery module 100 for the time duration.

Figure 12 is a flowchart of additional operations that may be executed and performed with the method 800, in accordance with an example implementation. At block 1200, operations include adjusting the target SoC over a life of the battery module 100 as the battery health parameters indicate a degradation in battery capacity of the battery module 100 and an increase in internal resistance of the battery module 100.

Figure 13 is a flowchart of additional operations that may be executed and performed with the method 800, in accordance with an example implementation. At block 1300, operations include gradually increasing the target SoC over the life of the battery module 100.

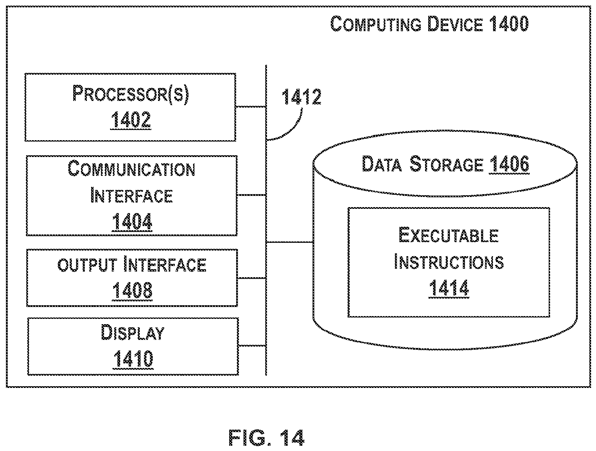

Figure 14 is a block diagram of a computing device 1400, according to an example implementation. The computing device 1400 can represent any of the controllers, modules, or devices described above (e.g., the battery charging controller 402, the battery state-of-health estimator 406, the coulomb counter 414, the SoC Determination Module 412, the battery charger 420). For example, the computing device 1400 can be used to perform operations of the flowcharts shown in Figures 8-13. The computing device 1400 may have processor(s) 1402, and also a communication interface 1404, data storage 1406, an output interface 1408, and a display 1410 each connected to a communication bus 1412. The computing device 1400 may also include hardware to enable communication within the computing device 1400 and between the computing device 1400 and other devices or modules (not shown). The hardware may include transmitters, receivers, and antennas, for example.

The communication interface 1404 may be a wireless interface and/or one or more wireline interfaces that allow for both short-range communication and long-range communication to one or more networks or to one or more remote devices. Such wireless interfaces may provide for communication under one or more wireless communication protocols, Bluetooth, WiFi (e.g., an institute of electrical and electronic engineers (IEEE) 802.11 protocol), Long-Term Evolution (LTE), cellular communications, near-field communication (NFC), and/or other wireless communication protocols. Such wireline interfaces may include an Ethernet interface, a Universal Serial Bus (USB) interface, or similar interface to communicate via a wire, a twisted pair of wires, a coaxial cable, an optical link, a fiber-optic link, or other physical connection to a wireline network. Thus, the communication interface 1404 may be configured to receive input data from one or more devices, sensors (e.g., the sensors 404), or modules, and may also be configured to send output data to other devices or modules (e.g., the battery state-of-health estimator 406, the SoC Determination Module 412, the coulomb counter 414, the battery charger 420, the battery module 100, etc. of the system 400).

The data storage 1406 may include or take the form of one or more computer-readable storage media that can be read or accessed by the processor(s) 1402. The computer-readable storage media can include volatile and/or non-volatile storage components, such as optical, magnetic, organic or other memory or disc storage, which can be integrated in whole or in part with the processor(s) 1402. The data storage 1406 is considered non-transitory computer readable media. In some examples, the data storage 1406 can be implemented using a single physical device (e.g., one optical, magnetic, organic or other memory or disc storage unit), while in other examples, the data storage 1406 can be implemented using two or more physical devices.

The data storage 1406 thus is a non-transitory computer readable storage medium, and executable instructions 1414 are stored thereon. The executable instructions 1414 include computer executable code. When the executable instructions 1414 are executed by the processor(s) 1402, the processor(s) 1402 are caused to perform operations of the computing device 1400 (e.g., the operations associated with the flowcharts shown in Figures 8-13 and the battery charging controller 402).

The processor(s) 1402 may be a general-purpose processor or a special purpose processor (e.g., digital signal processors, application specific integrated circuits, etc.). The processor(s) 1402 may receive inputs from the communication interface 1404, and process the inputs to generate outputs that are stored in the data storage 1406 and output to the display 1410. The processor(s) 1402 can be configured to execute the executable instructions 1414 (e.g., computer-readable program instructions) that are stored in the data storage 1406 and are executable to provide the functionality of the computing device 1400 described herein.

The output interface 1408 outputs information to the display 1410 or to other components as well. Thus, the output interface 1408 may be similar to the communication interface 1404 and can be a wireless interface (e.g., transmitter) or a wired interface as well.

The detailed description above describes various features and operations of the disclosed systems with reference to the accompanying figures. The illustrative implementations described herein are not meant to be limiting. Certain aspects of the disclosed systems can be arranged and combined in a wide variety of different configurations, all of which are contemplated herein.

Further, unless context suggests otherwise, the features illustrated in each of the figures may be used in combination with one another. Thus, the figures should be generally viewed as component aspects of one or more overall implementations, with the understanding that not all illustrated features are necessary for each implementation.

Additionally, any enumeration of elements, blocks, or steps in this specification or the claims is for purposes of clarity. Thus, such enumeration should not be interpreted to require or imply that these elements, blocks, or steps adhere to a particular arrangement or are carried out in a particular order.

Further, devices or systems may be used or configured to perform functions presented in the figures. In some instances, components of the devices and/or systems may be configured to perform the functions such that the components are actually configured and structured (with hardware and/or software) to enable such performance. In other examples, components of the devices and/or systems may be arranged to be adapted to, capable of, or suited for performing the functions, such as when operated in a specific manner.

By the term "substantially" it is meant that the recited characteristic, parameter, or value need not be achieved exactly, but that deviations or variations, including for example, tolerances, measurement error, measurement accuracy limitations and other factors known to skill in the art, may occur in amounts that do not preclude the effect the characteristic was intended to provide.

The arrangements described herein are for purposes of example only. As such, those skilled in the art will appreciate that other arrangements and other elements (e.g., machines, interfaces, operations, orders, and groupings of operations, etc.) can be used instead, and some elements may be omitted altogether according to the desired results. Further, many of the elements that are described are functional entities that may be implemented as discrete or distributed components or in conjunction with other components, in any suitable combination and location.

Various embodiments also include the following examples:
Example 1. A system (400) comprising:
   a battery module (100) having a plurality of battery cells (104), wherein the battery module (100) includes one or more sensors (404) providing sensor information indicative of a health status of the battery module (100);
   a battery charger (420) configured to provide electric power to the battery module (100) to charge the battery module (100); and
   a battery charging controller (402) comprising (i) one or more processors (1402), and (ii) data storage (1406) storing thereon instructions that, when executed by the one or more processors (1402), cause the battery charging controller (402) to perform operations comprising: determining (804), based on the sensor information received from the one or more sensors (404) of the battery module (100), battery health parameters of the battery module (100),
   determining (806), based on the battery health parameters, a target state-of-charge (SoC) indicating a target battery capacity to which the battery module (100) is to be charged,
   determining (808) an end-of-charge voltage (EOCV) (418) to be attained at an end of charging the battery module (100) to achieve the target SoC, and
   commanding (810) the battery charger (420) to charge the battery module (100) until the EOCV (418) is achieved.
Example 2. The system (400) of example 1, wherein the one or more sensors (404) include (i) an electric current sensor, (ii) a voltage sensor, or (iii) a temperature sensor.
Example 3. The system (400) of example 1 or 2, wherein the battery health parameters comprise one or more of (i) a battery capacity estimate (408) providing an estimate of a maximum battery capacity at a given point in a life of the battery module (100), (ii) a battery impedance estimate (410) providing an indication of an internal resistance of the battery module (100) at the given point in the life of the battery module (100).
Example 4. The system (400) of any of examples 1 to 3, further comprising:
   a coulomb counter (414) configured to measure accumulated energy added to and removed from the battery module (100), thereby tracking energy stored in the battery module (100) during charge and discharge modes, wherein the operations further comprise:
   adjusting (900) the target SoC based on input from the coulomb counter (414).
Example 5. The system (400) of any of examples 1 to 4, wherein the battery charging controller (402) has access to energy requirements (416) indicating energy output to be met by the battery module (100), and wherein determining (1000) the target SoC is further based on the energy requirements (416).
Example 6. The system (400) of example 5, wherein the operations further comprise: determining (1100), based on the energy requirements (416), a time duration for charging the battery module (100); and
   commanding (1102) the battery charger (420) to charge the battery module (100) for the time duration.
Example 7. The system (400) of any of examples 1 to 6, wherein the operations further comprise:
   adjusting (1200) the target SoC over a life of the battery module (100) as the battery health parameters indicate a degradation in battery capacity of the battery module (100) and an increase in internal resistance of the battery module (100).
Example 8. The system (400) of example 7, wherein adjusting the target SoC over the life of the battery module (100) comprises:
   gradually increasing (1300) the target SoC over the life of the battery module (100).
Example 9. A method (800) comprising:
   receiving (802), at a battery charging controller (402) of a battery module (100), from one or more sensors (404) of the battery module (100), sensor information indicative of a health status of the battery module (100);
   determining (804), by the battery charging controller (402), based on sensor information, battery health parameters of the battery module (100);
   determining (806), by the battery charging controller (402), based on the battery health parameters, a target state-of-charge (SoC) indicating a target battery capacity to which the battery module (100) is to be charged;
   determining (808), by the battery charging controller (402), an end-of-charge voltage (EOCV) (418) to be attained at an end of charging the battery module (100) to achieve the target SoC; and commanding (810), by the battery charging controller (402), a battery charger (420) to charge the battery module (100) until the EOCV (418) is achieved.
Example 10. The method (800) of example 9, further comprising:
   adjusting (900) the target SoC based on input from a coulomb counter (414) configured to measure accumulated energy added to and removed from the battery module (100), thereby tracking energy stored in the battery module (100) during charge and discharge modes.
Example 11. The method (800) of example 9 or 10, wherein the battery charging controller (402) has access to energy requirements (416) indicating energy output to be met by the battery module (100), wherein determining (1000) the target SoC is further based on the energy requirements (416).
Example 12. The method (800) of example 11, further comprising:
   determining (1100), based on the energy requirements (416), a time duration for charging the battery module (100); and
   commanding (1102) the battery charger (420) to charge the battery module (100) for the time duration.
Example 13. The method (800) of any of examples 9 to 12, further comprising:
   adjusting (1200) the target SoC over a life of the battery module (100) as the battery health parameters indicate a degradation in battery capacity of the battery module (100) and an increase in internal resistance of the battery module (100).
Example 14. The method (800) of example 13, wherein adjusting the target SoC over the life of the battery module (100) comprises:
   gradually increasing (1300) the target SoC over the life of the battery module (100).
Example 15. A non-transitory computer readable medium (1406) having stored therein instructions (1414) that, in response to execution by a battery charging controller (402) of a battery module (100), cause the battery charging controller (402) to perform operations comprising:
   determining (804), based on sensor information received from one or more sensors (404) of the battery module (100), battery health parameters of the battery module (100);
   determining (806), based on the battery health parameters, a target state-of-charge (SoC) indicating a target battery capacity to which the battery module (100) is to be charged;
   determining (808) an end-of-charge voltage (EOCV) (418) to be attained at an end of charging the battery module (100) to achieve the target SoC; and
   commanding (810) a battery charger (420) to charge the battery module (100) until the EOCV (418) is achieved.
Example 16. The non-transitory computer readable medium (1406) of example 15, wherein the operations further comprise:
   adjusting (900) the target SoC based on input from a coulomb counter (414) configured to measure accumulated energy added to and removed from the battery module (100), thereby tracking energy stored in the battery module (100) during charge and discharge modes.
Example 17. The non-transitory computer readable medium (1406) of example 15 or 16, wherein the battery charging controller (402) has access to energy requirements (416) indicating energy output to be met by the battery module (100), and wherein determining (1000) the target SoC is further based on the energy requirements (416).
Example 18. The non-transitory computer readable medium (1406) of example 17, wherein the operations further comprise:
   determining (1100), based on the energy requirements (416), a time duration for charging the battery module (100); and
   commanding (1102) the battery charger (420) to charge the battery module (100) for the time duration.
Example 19. The non-transitory computer readable medium (1406) of any of examples 15 to 18, wherein the battery health parameters comprise one or more of (i) a battery capacity estimate (408) providing an estimate of a maximum battery capacity at a given point in a life of the battery module (100), (ii) a battery impedance estimate (410) providing an indication of an internal resistance of the battery module (100) at the given point in the life of the battery module (100), and wherein the operations further comprise:
   adjusting (1200) the target SoC over the life of the battery module (100) as the battery health parameters indicate a degradation in battery capacity of the battery module (100) and an increase in internal resistance of the battery module (100).
Example 20. The non-transitory computer readable medium (1406) of example 19, wherein adjusting the target SoC over the life of the battery module (100) comprises:
   gradually increasing (1300) the target SoC over the life of the battery module (100).

While various aspects and implementations have been disclosed herein, other aspects and implementations will be apparent to those skilled in the art. The various aspects and implementations disclosed herein are for purposes of illustration and are not intended to be limiting, with the true scope being indicated by the following claims, along with the full scope of equivalents to which such claims are entitled. Also, the terminology used herein is for the purpose of describing particular implementations only, and is not intended to be limiting.

## Claims

1. A system (400) comprising:
a battery module (100) having a plurality of battery cells (104), wherein the battery module (100) includes one or more sensors (404) providing sensor information indicative of a health status of the battery module (100);
a battery charger (420) configured to provide electric power to the battery module (100) to charge the battery module (100); and
a battery charging controller (402) comprising (i) one or more processors (1402), and (ii) data storage (1406) storing thereon instructions that, when executed by the one or more processors (1402), cause the battery charging controller (402) to perform operations comprising:
determining (804), based on the sensor information received from the one or more sensors (404) of the battery module (100), battery health parameters of the battery module (100),
determining (806), based on the battery health parameters, a target state-of-charge (SoC) indicating a target battery capacity to which the battery module (100) is to be charged,
determining (808) an end-of-charge voltage (EOCV) (418) to be attained at an end of charging the battery module (100) to achieve the target SoC, and
commanding (810) the battery charger (420) to charge the battery module (100) until the EOCV (418) is achieved.

2. The system (400) of claim 1, wherein the one or more sensors (404) include (i) an electric current sensor, (ii) a voltage sensor, or (iii) a temperature sensor.

3. The system (400) of any of claims 1 to 2, wherein the battery health parameters comprise one or more of (i) a battery capacity estimate (408) providing an estimate of a maximum battery capacity at a given point in a life of the battery module (100), (ii) a battery impedance estimate (410) providing an indication of an internal resistance of the battery module (100) at the given point in the life of the battery module (100).

4. The system (400) of any of claims 1 to 3, further comprising:
a coulomb counter (414) configured to measure accumulated energy added to and removed from the battery module (100), thereby tracking energy stored in the battery module (100) during charge and discharge modes, wherein the operations further comprise:
adjusting (900) the target SoC based on input from the coulomb counter (414).

5. The system (400) of any of claims 1 to 4, wherein the battery charging controller (402) has access to energy requirements (416) indicating energy output to be met by the battery module (100), and wherein determining (1000) the target SoC is further based on the energy requirements (416).

6. The system (400) of any of claims 1 to 5, wherein the operations further comprise:
determining (1100), based on the energy requirements (416), a time duration for charging the battery module (100); and
commanding (1102) the battery charger (420) to charge the battery module (100) for the time duration.

7. The system (400) of any of claims 1 to 6, wherein the operations further comprise:
adjusting (1200) the target SoC over a life of the battery module (100) as the battery health parameters indicate a degradation in battery capacity of the battery module (100) and an increase in internal resistance of the battery module (100).

8. The system (400) of any of claims 1 to 7, wherein adjusting the target SoC over the life of the battery module (100) comprises:
gradually increasing (1300) the target SoC over the life of the battery module (100).

9. A method (800) comprising:
receiving (802), at a battery charging controller (402) of a battery module (100), from one or more sensors (404) of the battery module (100), sensor information indicative of a health status of the battery module (100);
determining (804), by the battery charging controller (402), based on sensor information, battery health parameters of the battery module (100);
determining (806), by the battery charging controller (402), based on the battery health parameters, a target state-of-charge (SoC) indicating a target battery capacity to which the battery module (100) is to be charged;
determining (808), by the battery charging controller (402), an end-of-charge voltage (EOCV) (418) to be attained at an end of charging the battery module (100) to achieve the target SoC; and
commanding (810), by the battery charging controller (402), a battery charger (420) to charge the battery module (100) until the EOCV (418) is achieved.

10. The method (800) of claim 9, further comprising:
adjusting (900) the target SoC based on input from a coulomb counter (414) configured to measure accumulated energy added to and removed from the battery module (100), thereby tracking energy stored in the battery module (100) during charge and discharge modes.

11. The method (800) of any of claims 9 to 10, wherein the battery charging controller (402) has access to energy requirements (416) indicating energy output to be met by the battery module (100), wherein determining (1000) the target SoC is further based on the energy requirements (416).

12. The method (800) of any of claims 9 to 11, further comprising:
determining (1100), based on the energy requirements (416), a time duration for charging the battery module (100); and
commanding (1102) the battery charger (420) to charge the battery module (100) for the time duration.

13. The method (800) of any of claims 9 to 12, further comprising:
adjusting (1200) the target SoC over a life of the battery module (100) as the battery health parameters indicate a degradation in battery capacity of the battery module (100) and an increase in internal resistance of the battery module (100).

14. The method (800) of any of claims 9 to 13, wherein adjusting the target SoC over the life of the battery module (100) comprises:
gradually increasing (1300) the target SoC over the life of the battery module (100).
